(19) Europäisches Patentamt
European Patent Office
Office européen des brevets

(11) EP 4 679 498 A1

(12) **EUROPEAN PATENT APPLICATION**
published in accordance with Art. 153(4) EPC

(43) Date of publication:
**14.01.2026 Bulletin 2026/03**

(21) Application number: **24767039.1**

(22) Date of filing: **01.03.2024**

(51) International Patent Classification (IPC):
***H01L 21/768*** (2006.01) ***C08G 59/42*** (2006.01)
***C08G 63/42*** (2006.01) ***C08G 63/688*** (2006.01)
***H01L 21/312*** (2006.01) ***H01L 23/532*** (2006.01)

(52) Cooperative Patent Classification (CPC):
**C08G 59/42; C08G 63/42; C08G 63/688; H01L 21/768; H01L 23/532**

(86) International application number:
**PCT/JP2024/007708**

(87) International publication number:
**WO 2024/185670 (12.09.2024 Gazette 2024/37)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **03.03.2023 JP 2023032707**

(71) Applicant: **Nissan Chemical Corporation**
**Tokyo 103-6119 (JP)**

(72) Inventors:
- **KINOSHITA Kazuhiko**
  **Toyama-shi, Toyama 939-2792 (JP)**
- **NISHITA Tokio**
  **Toyama-shi, Toyama 939-2792 (JP)**
- **KISHIOKA Takahiro**
  **Toyama-shi, Toyama 939-2792 (JP)**

(74) Representative: **Hoffmann Eitle**
**Patent- und Rechtsanwälte PartmbB**
**Arabellastraße 30**
**81925 München (DE)**

(54) **COMPOSITION FOR FORMING CAVITY**

(57) Provided are a cavity forming composition suitable for forming a cavity by heating between conductive wiring patterns on a semiconductor substrate, and the like. A cavity forming composition for forming a cavity between conductive wiring patterns on a semiconductor substrate, the cavity forming composition containing: a polymer containing an alicyclic hydrocarbon structural moiety and not containing an aromatic hydrocarbon structural moiety; and a solvent.

FIG. 1F

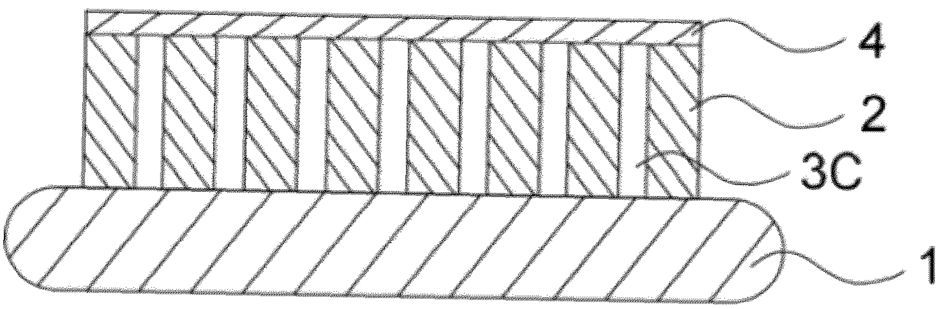


EP 4 679 498 A1

## Description

### Technical Field

The present invention relates to a cavity forming composition for forming a cavity between conductive wiring patterns. The present invention also relates to a method for manufacturing a semiconductor element using the cavity forming composition.

### Background Art

In recent years, a semiconductor element tends to be highly integrated, and wiring has been miniaturized accordingly. When the wiring is miniaturized, a parasitic capacitance between wires increases. When the parasitic capacitance between the wires increases, noise or delay occurs in an electric signal.

Therefore, as a method for reducing the parasitic capacitance between the wires, a method for forming a gap between the wires has been proposed (see Patent Literature 1). In this proposed technique, in a method for manufacturing a semiconductor device, a space is formed between wires by a step of selectively covering a surface of a predetermined first insulating film of a semiconductor substrate to form a plurality of wires of the same layer, a step of forming an organic resin film on the surface of the first insulating film selectively covered with the wires, a step of thinning the organic resin film to expose a surface of the wires, a step of depositing a sparse second insulating film on the entire surface, a step of removing the organic resin film, and a step of depositing a dense third insulating film. In the step of removing the organic resin film, $O_2$ plasma treatment is performed. In this step, by performing the $O_2$ plasma treatment, carbon in the second insulating film (organic SOG film) is removed and the second insulating film is changed into a sparse film. As a result, $O_2$ plasma passes through the second insulating film, and the organic resin film (resist film) can be removed (see paragraph [0023] of Patent Literature 1). In addition, in order to reduce damage to the substrate due to the $O_2$ plasma treatment, a step of removing the organic resin film by heat has also been studied (see Patent Literature 2).

### Citation List

#### Patent Literatures

Patent Literature 1: JP H09-172068 A
Patent Literature 2: JP 2021-114524 A

### Summary of Invention

#### Technical Problem

In the technique of Patent Literature 1, in the $O_2$ plasma treatment for removing the organic resin film, it is necessary for the $O_2$ plasma to pass through the second insulating film, and therefore the material of the second insulating film is largely restricted. In addition, an apparatus for the $O_2$ plasma treatment is required.

On the other hand, when the organic resin film can be removed by heating as in the technique of Patent Literature 2, the restriction of the second insulating film is relatively small, and a heating apparatus can relatively suppress cost as compared with the $O_2$ plasma treatment apparatus.

However, from the viewpoint of providing a cavity forming composition suitable for forming a cavity by heating between conductive wiring patterns on a semiconductor substrate, the cavity forming composition having less residue after thermal decomposition so as not to affect electrical characteristics of a semiconductor device, the thermally decomposable polymer described in Patent Literature 2 cannot be said to be sufficient, and there is room for study.

The present invention has been made in view of the above circumstances, and an object thereof is to provide a cavity forming composition suitable for forming a cavity by heating between conductive wiring patterns on a semiconductor substrate, and a method for manufacturing a semiconductor element using the cavity forming composition.

#### Solution to Problem

The present inventors have conducted intensive studies in order to solve the above-described problems, and as a result, have found that a cavity forming composition using a material having an alicyclic hydrocarbon structure in a main chain of a polymer exhibits high thermal decomposability, has less residue, and can solve the above-described problems;

on the other hand, a cavity forming composition using a material having an aromatic hydrocarbon structure in a main chain of a polymer has many residues and is not suitable as a cavity forming composition, thereby completing the present invention.

That is, the present invention includes the following aspects.

[1] A cavity forming composition for forming a cavity between conductive wiring patterns on a semiconductor substrate, the cavity forming composition containing:
a polymer containing an alicyclic hydrocarbon structural moiety and not containing an aromatic hydrocarbon structural moiety; and a solvent.
[2] The cavity forming composition according to [1], wherein the polymer is formed of a condensate of a diepoxy compound and a dicarboxylic acid.
[3] The cavity forming composition according to [1] or [2], wherein the polymer contains a disulfide bond.
[4] The cavity forming composition according to any one of [1] to [3], further containing an acid catalyst.
[5] A method for manufacturing a semiconductor element, the method including:

a step (A) of applying the cavity forming composition according to any one of [1] to [4] onto a semiconductor substrate on which conductive wiring patterns are formed;
a step (B) of heating the semiconductor substrate after the step (A) to form a cavity forming film formed of the cavity forming composition between the conductive wiring patterns;
a step (C) of forming an insulating layer on the conductive wiring patterns and the cavity forming film between the conductive wiring patterns after the step (B); and
a step (D) of heating the semiconductor substrate to burn out the cavity forming film after the step (C).

[6] The method for manufacturing a semiconductor element according to [5], wherein

in the step (B), the cavity forming film is formed also on the conductive wiring patterns, and
the method comprises a step (E) of removing the cavity forming film on the conductive wiring patterns before the step (C).

[7] The method for manufacturing a semiconductor element according to [5] or [6], the method including
a step (F) of removing the cavity forming film which is present on the conductive wiring patterns and is formed of the cavity forming composition between the step (A) and the step (B).
[8] The method for manufacturing a semiconductor element according to any one of [5] to [7], wherein in the step (C), the insulating layer is formed by chemical vapor deposition.

Advantageous Effects of Invention

According to the present invention, it is possible to provide a cavity forming composition suitable for forming a cavity by heating between conductive wiring patterns on a semiconductor substrate, and a method for manufacturing a semiconductor element using the cavity forming composition.

Brief Description of Drawings

Fig. 1A is a schematic cross-sectional view for explaining an example of a method for manufacturing a semiconductor element (part 1).
Fig. 1B is a schematic cross-sectional view for explaining the example of the method for manufacturing a semiconductor element (part 2).
Fig. 1C is a schematic cross-sectional view for explaining the example of the method for manufacturing a semiconductor element (part 3).
Fig. 1D is a schematic cross-sectional view for explaining the example of the method for manufacturing a semiconductor element (part 4).
Fig. 1E is a schematic cross-sectional view for explaining the example of the method for manufacturing a semiconductor element (part 5).
Fig. 1F is a schematic cross-sectional view for explaining the example of the method for manufacturing a semiconductor element (part 6).

Description of Embodiments

(Cavity forming composition)

A cavity forming composition of the present invention is a composition for forming a cavity between conductive wiring patterns on a semiconductor substrate.

The cavity forming composition contains a polymer and a solvent.

The polymer contains an alicyclic hydrocarbon structural moiety and does not contain an aromatic hydrocarbon structural moiety.

<Polymer>

The polymer according to the present invention is a polymer containing an alicyclic hydrocarbon structural moiety and not containing an aromatic hydrocarbon structural moiety.

The alicyclic hydrocarbon structure refers to a structure related to a cyclic hydrocarbon excluding an aromatic hydrocarbon among cyclic hydrocarbons.

The alicyclic hydrocarbon may be a saturated hydrocarbon or an unsaturated hydrocarbon, but is more preferably a saturated hydrocarbon.

The alicyclic hydrocarbon structure is not particularly limited as long as the effect of the present invention is exhibited, but for example, a structure of a 5-membered or 6-membered alicyclic hydrocarbon is preferable.

The polymer according to the present invention may be a polymer obtained by combining and reacting any monomers as long as it has an alicyclic hydrocarbon structure and does not have an aromatic hydrocarbon structural moiety, but is preferably, for example, a polymer, which is a condensate of a diepoxy compound and a dicarboxylic acid, obtained by reacting a diepoxy compound and a dicarboxylic acid.

The diepoxy compound is not particularly limited as long as it is a compound having two epoxy groups, but it preferably has an alicyclic hydrocarbon ring. The alicyclic hydrocarbon ring is preferably a cyclohexane ring.

The dicarboxylic acid is not particularly limited as long as it is a compound having two carboxy groups.

Examples of a preferred embodiment of the polymer according to the present invention include a polymer obtained by reacting a diepoxy compound exemplified below with a dicarboxylic acid exemplified below. The diepoxy compound and the dicarboxylic acid are used in appropriate combination so that a polymer which is a condensate obtained by reacting the diepoxy compound and the dicarboxylic acid has an alicyclic hydrocarbon structure.

Examples of the diepoxy compound used for obtaining the polymer include those shown below.

[Chem. 1]

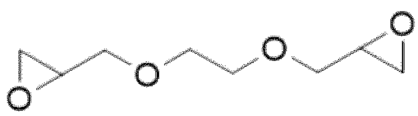
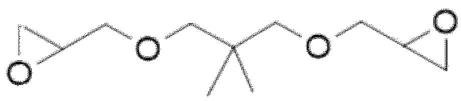
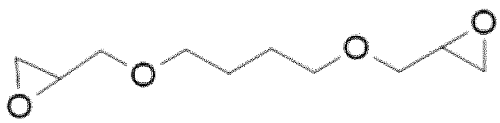
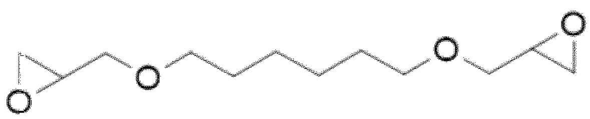
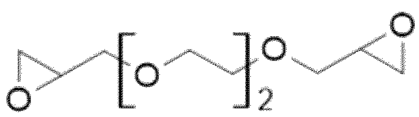
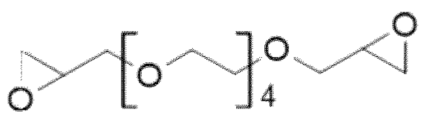
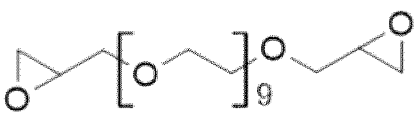
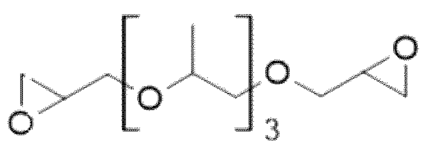

[Chem. 2]

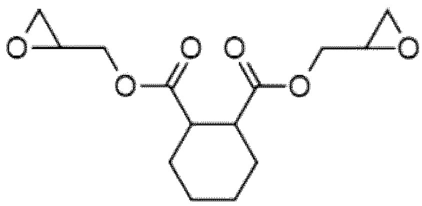

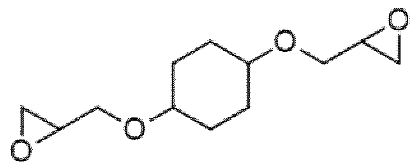

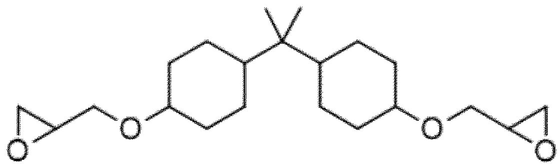

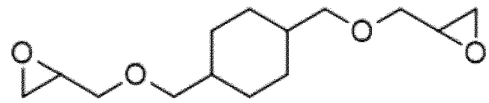

[Chem. 3]

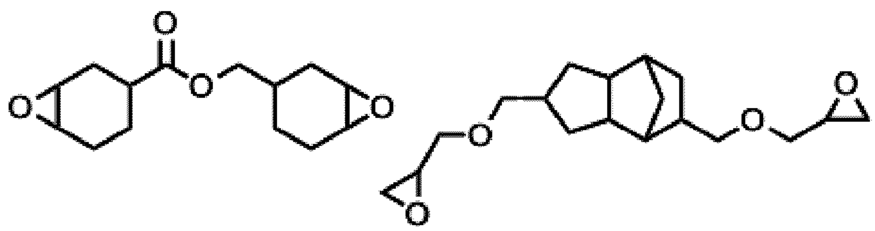

Examples of the dicarboxylic acid used for obtaining the polymer include those shown below.

[Chem. 4]

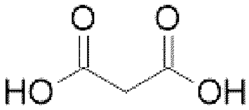
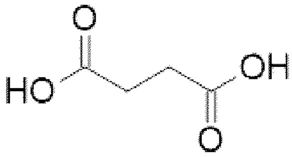
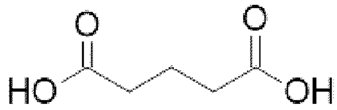
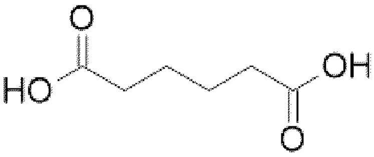
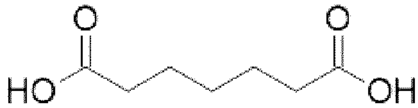
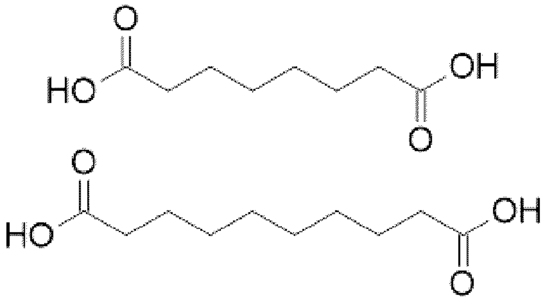
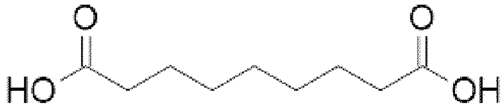
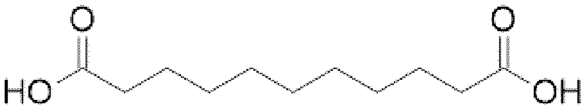
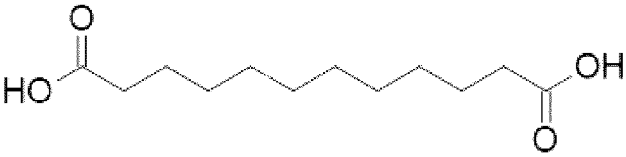

[Chem. 5]

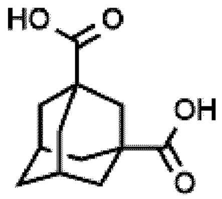

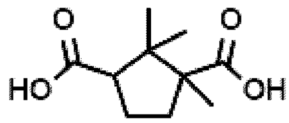

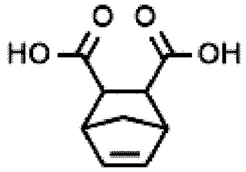

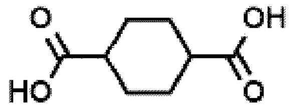

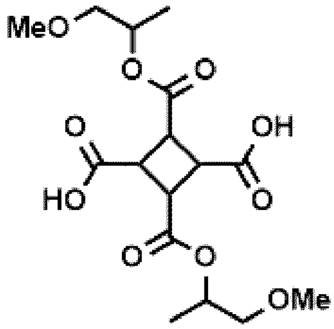

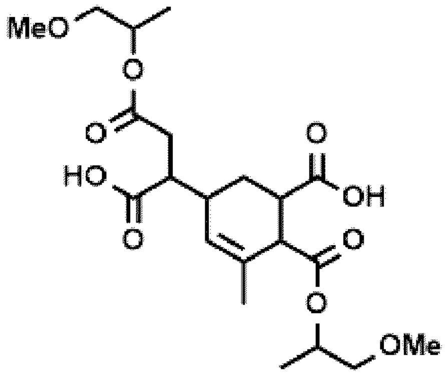

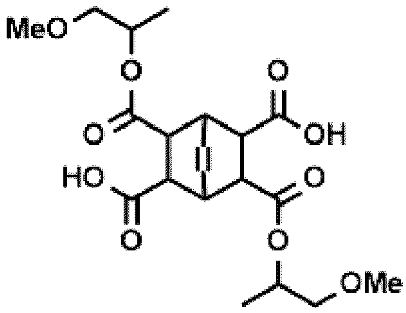

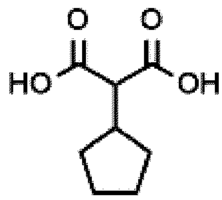

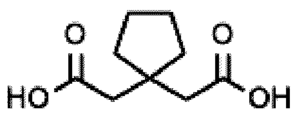

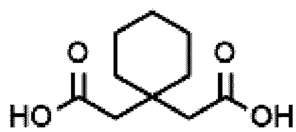

[Chem. 6]

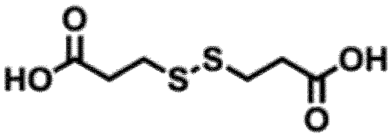
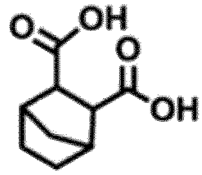
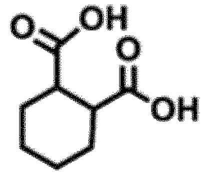
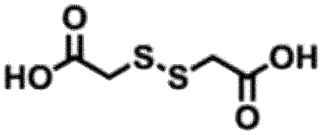
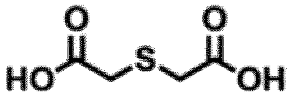
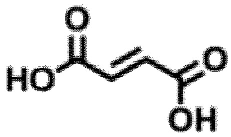
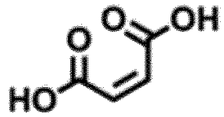
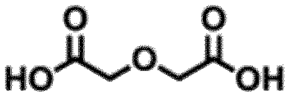

The polymer according to the present invention may contain, for example, a disulfide bond.

In the production of a polymer containing a disulfide bond, it is preferable to use a dicarboxylic acid used for the production of the polymer having a disulfide bond, for example, as exemplified in the exemplary compounds of the dicarboxylic acid.

The polymer according to the present invention may be, for example, a polymer formed by crosslinking in the presence of an acid catalyst.

Therefore, as a preferred embodiment of the cavity forming composition of the present invention, a cavity forming composition further containing an acid catalyst in addition to a polymer containing an alicyclic hydrocarbon structural moiety and not containing an aromatic hydrocarbon structural moiety and a solvent can be mentioned.

The cavity forming composition is suitably used for manufacturing a semiconductor element, including the following steps (A) to (D).

Step (A): a step of applying the cavity forming composition onto a semiconductor substrate on which conductive wiring patterns are formed

Step (B): a step of heating the semiconductor substrate after the step (A) to form a cavity forming film formed of the cavity forming composition between the conductive wiring patterns

Step (C): a step of forming an insulating layer on the conductive wiring patterns and the cavity forming film between the conductive wiring patterns after the step (B)

Step (D): a step of heating the semiconductor substrate to burn out the cavity forming film after the step (C)

When the cavity forming film is softened and deformed by application of heat to the cavity forming film during formation of the insulating layer in the step (C), a uniform insulating layer is hardly formed. However, since a cavity forming film formed by the cavity forming composition of the present invention is hardly softened, a uniform insulating layer can be formed.

In the step (D), when heating for burning out the cavity forming film is performed, since the polymer contained in the cavity forming composition of the present invention exhibits a high decomposition ratio, the cavity forming film can be burned out so that no residue of the cavity forming film remains.

Therefore, the cavity forming composition of the present invention is suitable for forming a cavity by heating between conductive wiring patterns on a semiconductor substrate.

In a preferred embodiment of the cavity forming composition of the present invention, a glass transition temperature of the cavity forming film formed of the cavity forming composition is sufficiently high, for example, 86°C or higher. As the glass transition temperature is higher, a more uniform insulating layer can be formed. The glass transition temperature is more preferably 90°C or higher, still more preferably 93°C or higher, and particularly preferably 100°C or higher. An upper limit value of the glass transition temperature is not particularly limited, but for example, the glass transition temperature may be 130°C or lower, or 120°C or lower.

The glass transition temperature can be measured, for example, by the following method.

The cavity forming composition is applied by spin coating to prepare a coating film on a silicon substrate at a predetermined baking temperature (for example, 205°C or 215°C). The coating film has a film thickness of 40 nm to 50 nm. Then, the coating film is scraped, and the obtained powder is subjected to differential scanning calorimetry.

For the measurement, differential scanning calorimetry (DSC) is used. First, the temperature is raised to 140°C to erase a thermal history. Thereafter, the temperature is lowered to 0°C at a temperature lowering rate of 20°C/min, and measurement is performed again at a temperature rising rate of 20°C/min. A temperature indicating an inflection point of a transition region appearing stepwise in a thermogram at this time is defined as the glass transition temperature. Note that, for a result that no inflection point is observed, the glass transition temperature is defined as 100°C or higher. An apparatus used is Q2000 manufactured by TA Instruments, and a sample amount is about 5 mg.
The baking temperature may be, for example, the heating temperature in the step (B).
In addition, in a preferred embodiment of the cavity forming composition of the present invention, when a cavity forming film formed of the cavity forming composition is heated at 400°C for 30 minutes under a nitrogen atmosphere, a decomposition ratio is 95% or more. As the decomposition ratio is larger, a dielectric constant of a cavity (for example, a cavity formed in the step (D)) to be formed can be lower. The decomposition ratio is preferably 96% or more, more preferably 97% or more, still more preferably 98% or more, and particularly preferably 99% or more.
The decomposition ratio can be measured, for example, by the following method.
The cavity forming composition is applied by spin coating to prepare a coating film on a silicon substrate at a predetermined baking temperature (for example, 205°C or 215°C). The coating film has a film thickness of 40 nm to 50 nm. The baking temperature may be, for example, the heating temperature in the step (B).
The thickness of the coating film is measured using VM-3210 (manufactured by SCREEN Semiconductor Solutions Co., Ltd.). Thereafter, the silicon substrate to which the cavity forming composition has been applied is heated for 30 minutes with a plate preheated to 400°C under a nitrogen atmosphere. Finally, the film thickness of the resulting coating film on the substrate is measured again using RE-3100 and RE-3500 (manufactured by SCREEN Semiconductor Solutions Co., Ltd.). From the obtained results, a thermal decomposition ratio of the coating film is calculated using the following formula 1.

$$(\text{Decomposition ratio } [\%]) = 100 \times (1 - T_1/T_0) \quad \text{Formula 1}$$

$T_0$ = film thickness of coating film before firing decomposition
$T_1$ = film thickness of coating film after firing decomposition

The content of the polymer in the cavity forming composition is not particularly limited, but is preferably 50% by mass to 100% by mass, more preferably 80% by mass to 100% by mass, and particularly preferably 95% by mass to 100% by mass with respect to a nonvolatile component (that is, a component excluding the solvent) in the cavity forming composition. Note that when the cavity forming composition contains an acid catalyst for crosslinking the polymer, an upper limit of the content of the polymer is preferably 99.9% by mass or less.

<<Method for manufacturing polymer>>

The polymerization method for producing a polymer is not particularly limited, and a polymer can be produced using a generally known method.
For example, a polymer can be produced by dissolving a diepoxy compound, a dicarboxylic acid, and a catalyst in an organic solvent, and then reacting them under a heated nitrogen atmosphere.
The used organic solvent is not particularly limited, and examples thereof include propylene glycol monomethyl ether and propylene glycol monopropyl ether.
Examples of the used catalyst include tetrabutylphosphonium bromide, ethyltriphenylphosphonium bromide, ethyltriphenylphosphonium iodide, benzyltriphenylphosphonium chloride, and butyltriphenylphosphonium bromide.
The reaction temperature is, for example, 80 to 120°C.
The reaction time is, for example, 1 to 48 hours.

<Solvent>

The solvent used in the cavity forming composition is not particularly limited as long as it is a solvent capable of uniformly dissolving solid contained components at normal temperature, but is preferably an organic solvent generally used in a chemical solution for a semiconductor lithography step. Specific examples thereof include ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether, propylene glycol monoethyl ether, propylene glycol monomethyl ether acetate, propylene glycol propyl ether acetate, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl

3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxy cyclopentane, anisole, γ-butyrolactone, N-methylpyrrolidone, N,N-dimethylformamide, and N,N-dimethylacetamide. These solvents can be used alone or in combination of two or more kinds thereof.

Among these solvents, propylene glycol monomethyl ether, propylene glycol monomethyl ether acetate, ethyl lactate, butyl lactate, and cyclohexanone are preferable. In particular, propylene glycol monomethyl ether and propylene glycol monomethyl ether acetate are preferable.

<Acid catalyst>

The cavity forming composition may further contain an acid catalyst.

The acid catalyst contained in the cavity forming composition is used, and the polymer according to the present invention may be crosslinked with the acid catalyst.

The polymer according to the present invention is crosslinked with the acid catalyst so that the glass transition temperature (Tg) of the cavity forming film formed by applying the cavity forming composition containing the polymer can be improved.

Examples of the acid catalyst include a sulfonic acid compound.

Examples of the sulfonic acid compound include p-toluenesulfonic acid, pyridinium trifluoromethanesulfonate (Py-TFMS), pyridinium-p-toluenesulfonate, 5-sulfosalicylic acid, 4-chlorobenzenesulfonic acid, 4-hydroxybenzenesulfonic acid, pyridinium-4-hydroxybenzenesulfonate, n-dodecylbenzenesulfonic acid, 4-nitrobenzenesulfonic acid, benzenedisulfonic acid, 1-naphthalenesulfonic acid, trifluoromethanesulfonic acid, and camphorsulfonic acid.

The content of the acid catalyst in the cavity forming composition is not particularly limited, but is, for example, 0 to 5% by mass with respect to the polymer.

<Other components>

A surfactant can be further added to the cavity forming composition in order to further improve a coating property for surface unevenness without generating a pinhole, a striation, and the like. Examples of the surfactant include: a polyoxyethylene alkyl ether such as polyoxyethylene lauryl ether, polyoxyethylene stearyl ether, polyoxyethylene cetyl ether, or polyoxyethylene oleyl ether; a polyoxyethylene alkyl allyl ether such as polyoxyethylene octyl phenol ether or polyoxyethylene nonyl phenol ether; a polyoxyethylene/polyoxypropylene block copolymer; a sorbitan fatty acid ester such as sorbitan monolaurate, sorbitan monopalmitate, sorbitan monostearate, sorbitan monooleate, sorbitan trioleate, or sorbitan tristearate; a nonionic surfactant such as a polyoxyethylene sorbitan fatty acid ester such as polyoxyethylene sorbitan monolaurate, polyoxyethylene sorbitan monopalmitate, polyoxyethylene sorbitan monostearate, polyoxyethylene sorbitan trioleate, or polyoxyethylene sorbitan tristearate; a fluorine-based surfactant such as F-top EF301, EF303, and EF352 (trade names, manufactured by TOCHEM PRODUCTS CO., LTD.), Megafac F171, F173, R-30, and R-40 (trade names, manufactured by DIC Corporation), Fluorad FC430 and FC431 (trade names, manufactured by Sumitomo 3M Limited), or AsahiGuard AG710, Surflon S-382, SC101, SC102, SC103, SC104, SC105, and SC106 (trade names, manufactured by Asahi Glass Co., Ltd.); and organosiloxane polymer KP341 (manufactured by Shin-Etsu Chemical Co., Ltd.). The blending amount of these surfactants is usually 2.0% by mass or less, and preferably 1.0% by mass or less with respect to the total solid content of the protective-film forming composition. These surfactants may be added alone, or two or more types thereof can also be added in combination.

A nonvolatile component contained in the cavity forming composition, that is, a component excluding the solvent is, for example, 0.01% by mass to 10% by mass.

(Method for producing semiconductor element)

A method for manufacturing a semiconductor element of the present invention includes the following steps (A) to (D).

Step (A): a step of applying the cavity forming composition of the present invention onto a semiconductor substrate on which conductive wiring patterns are formed

Step (B): a step of heating the semiconductor substrate after the step (A) to form a cavity forming film formed of the cavity forming composition between the conductive wiring patterns

Step (C): a step of forming an insulating layer on the conductive wiring patterns and the cavity forming curing material between the conductive wiring patterns after the step (B),

Step (D): a step of heating the semiconductor substrate to burn out the cavity forming film after the step (C)

<Step (A)>

The step (A) is a step of applying the cavity forming composition of the present invention onto a semiconductor substrate on which conductive wiring patterns are formed.
Examples of the semiconductor substrate include a silicon wafer, a germanium wafer, and a compound semiconductor wafer such as gallium arsenide, indium phosphide, gallium nitride, indium nitride, or aluminum nitride.
The material, size, and shape of the conductive wiring pattern are not particularly limited.
Examples of the material of the conductive wiring pattern include copper, cobalt, ruthenium, molybdenum, chromium, tungsten, manganese, rhodium, nickel, palladium, platinum, silver, gold, and aluminum.
An insulating layer may be formed on the conductive wiring pattern.
Examples of the material of the insulating layer include silicon dioxide, silicon oxycarbide, silicon oxynitride, silicon nitride, silicon carbon nitride (SiCN), aluminum nitride, aluminum oxynitride, and aluminum oxide.
Examples of a method for forming the insulating layer include vapor deposition.
The line width of each wire of the conductive wiring pattern is not particularly limited, but is, for example, 3 nm to 50 nm.
The width of a space between the wires of the conductive wiring pattern is not particularly limited, but is, for example, 3 nm to 50 nm.
A method for forming the conductive wiring pattern is not particularly limited, and for example, a conventionally known lithography process can be used.
The cavity forming composition is applied onto, for example, a semiconductor substrate by an appropriate application method such as a spinner or a coater.

<Step (B)>

The step (B) is a step of heating the semiconductor substrate after the step (A) to form a cavity forming film formed of the cavity forming composition between the conductive wiring patterns.
The semiconductor substrate is heated using, for example, a heating means such as a hot plate.
When the acid catalyst that crosslinks the polymer is contained in the cavity forming composition, in the step (B), the semiconductor substrate is heated to form a crosslinked structure of the polymer. As a result, a cavity forming film formed of the cavity forming composition containing a crosslinked polymer is obtained.
The heating temperature here can be appropriately selected according to the type of the polymer, the type of the acid catalyst optionally contained in the cavity forming composition, and the like, but is preferably 200 to 260°C.
The heating time is not particularly limited, but is preferably 30 seconds to 2 minutes.

<Step (C)>

The step (C) is a step of forming an insulating layer on the conductive wiring patterns and the cavity forming film between the conductive wiring patterns after the step (B).
The material of the insulating layer is not particularly limited, and may be an organic material or an inorganic material. When the insulating layer is formed of an inorganic material, examples of the material include silicon dioxide, silicon oxycarbide, silicon oxynitride, silicon nitride, silicon carbon nitride (SiCN), aluminum nitride, aluminum oxynitride, aluminum oxide, tantalum oxide, titanium oxide, yttrium oxide, lanthanum oxide, hafnium oxide, zirconium oxide, and mixtures thereof.
The thickness of the insulating layer is not particularly limited, but is, for example, 0.2 nm to 10 nm.
A method for forming the insulating layer is not particularly limited, but a chemical vapor deposition method (CVD method) is preferable.
That is, in the step (C), the insulating layer is preferably formed by chemical vapor deposition.

<Step (D)>

The step (D) is a step of heating the semiconductor substrate to burn out the cavity forming film after the step (C).
When the cavity forming film is heated, the cavity forming film is thermally decomposed and burned out due to thermal decomposition of the polymer.
The heating temperature here is not particularly limited as long as it is a temperature at which the cavity forming film disappears, and can be appropriately selected according to the type of the polymer and the like, but is preferably 300 to 500°C.
The heating time is not particularly limited, but is preferably 30 to 90 minutes.
A burning amount (decomposition ratio) of the cavity forming film is desirably 100%, but does not have to be

100%, and may be 99.9% or less. The decomposition ratio is preferably 90% or more, more preferably 95% or more, more preferably 96% or more, more preferably 97% or more, still more preferably 98% or more, and particularly preferably 99% or more.

<Step (E)>

In the step (B), the cavity forming film may be formed also on the conductive wiring patterns. In this case, the method for manufacturing a semiconductor element preferably includes a step (E) of removing the cavity forming film on the conductive wiring patterns before the step (C).

The cavity forming film on the conductive wiring pattern can be removed by, for example, etching the cavity forming film. The etching may be wet etching or dry etching.

<Step (F)>

A step (F) of removing the cavity forming composition which is present on the conductive wiring patterns may be included between the step (A) and the step (B).

The cavity forming composition on the conductive wiring pattern can be removed by, for example, etching the cavity forming composition. The etching may be wet etching or dry etching.

Hereinafter, an example of the method for manufacturing a semiconductor element will be described with reference to Figs. 1A to 1F.

First, as illustrated in Fig. 1A, a semiconductor substrate 1 on which conductive wiring patterns 2 are formed is prepared.

Subsequently, as the step (A), the cavity forming composition is applied onto the semiconductor substrate 1 on which the conductive wiring patterns 2 are formed. As a result, a cavity forming composition 3A is disposed on the conductive wiring patterns 2 and in a gap between the conductive wiring patterns 2 (Fig. 1B).

Subsequently, as the step (B), the semiconductor substrate 1 is heated. As a result, a cavity forming film 3B formed of the cavity forming composition is formed on the conductive wiring patterns 2 and in a gap between the conductive wiring patterns 2 (Fig. 1C).

Subsequently, as the step (E), the cavity forming film 3B on the conductive wiring patterns 2 is removed (Fig. 1D).

Subsequently, as the step (C), an insulating layer 4 is formed on the conductive wiring patterns 2 and the cavity forming film 3B in a gap between the conductive wiring patterns 2 (Fig. 1E).

Subsequently, as the step (D), the semiconductor substrate 1 is heated, and the cavity forming film 3B between the conductive wiring patterns 2 is burned out to form a cavity 3C between the conductive wiring patterns 2.

As described above, a cavity is formed between the conductive wiring patterns of the semiconductor substrate.

Examples

Next, the contents of the present invention will be specifically described with reference to examples, but the present invention is not limited thereto.

The weight average molecular weight of the polymer shown in the following examples is a measurement result obtained by gel permeation chromatography (hereinafter, abbreviated as GPC). For the measurement, a GPC apparatus manufactured by Tosoh Corporation was used, and measurement conditions and the like are as follows.

Column temperature: 40
Flow rate: 0.35 ml/min
Eluent: tetrahydrofuran (THF)
Standard sample: polystyrene (manufactured by Tosoh Corporation)

The compounds used in Examples and Comparative Examples are shown below.

[Chem. 7]

EX-216L

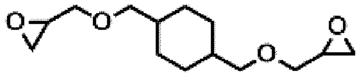

EX-252

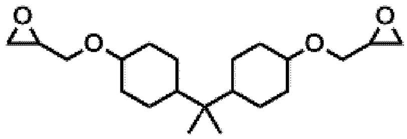

EX-711

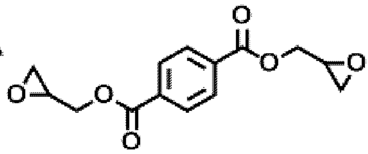

CELLOXIDE 2021P

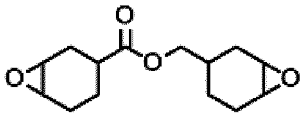

EP-4088L

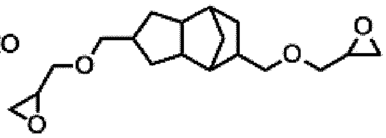

HP-4032SS

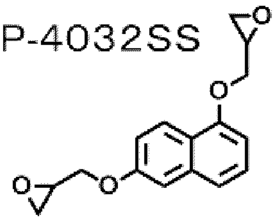

[Chem. 8]

DTDPA

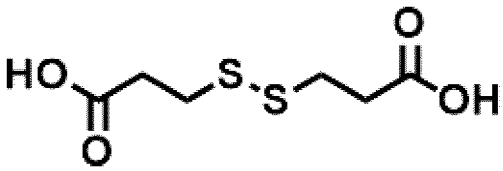

5HIPA

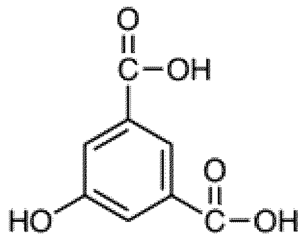

<Synthesis Example 1>

In a reaction vessel equipped with a thermometer, a cooling tube, and a stirrer, 80.00 g of propylene glycol monomethyl ether, 10.95 g of 2,2'-[cyclohexane-1,4-diylbis(methyleneoxymethylene)]bisoxirane (EX-216L, product of Nagase ChemteX Corporation), 8.11 g of 3,3'-dithiodipropionic acid (DTDPA) (product of Tokyo Chemical Industry Co., Ltd.), and 0.94 g of tetrabutylphosphonium bromide (product of Tokyo Chemical Industry Co., Ltd.) were dissolved, and the temperature was raised to 105°C under a nitrogen atmosphere.

The resulting mixture was stirred at 105°C for 24 hours under a nitrogen atmosphere to obtain a solution containing a copolymer. As a result of GPC analysis of the obtained polymer, the weight average molecular weight (in terms of standard polystyrene) Mw was 4530.

<Synthesis Example 2>

In a reaction vessel equipped with a thermometer, a cooling tube, and a stirrer, 80.00 g of propylene glycol monomethyl ether, 12.76 g of diglycidyl ether of 2,2-bis(4-hydroxycyclohexyl)propane (EX-252, product of Nagase ChemteX Corporation), 6.49 g of 3,3'-dithiodipropionic acid (DTDPA) (product of Tokyo Chemical Industry Co., Ltd.), and 0.75 g of tetrabutylphosphonium bromide (product of Tokyo Chemical Industry Co., Ltd.) were dissolved, and the temperature was raised to 105°C under a nitrogen atmosphere.

The resulting mixture was stirred at 105°C for 24 hours under a nitrogen atmosphere to obtain a solution containing a copolymer. As a result of GPC analysis of the obtained polymer, the weight average molecular weight (in terms of standard polystyrene) Mw was 5410.

<Synthesis Example 3>

In a reaction vessel equipped with a thermometer, a cooling tube, and a stirrer, 80.00 g of propylene glycol monomethyl ether, 10.20 g of 3,4-epoxycyclohexylmethyl (3,4-epoxy)cyclohexanecarboxylate (CELLOXIDE2021P,

product of Daicel Corporation), 8.79 g of 3,3'-dithiodipropionic acid (DTDPA) (product of Tokyo Chemical Industry Co., Ltd.), and 1.01 g of tetrabutylphosphonium bromide (product of Tokyo Chemical Industry Co., Ltd.) were dissolved, and the temperature was raised to 105°C under a nitrogen atmosphere.

The resulting mixture was stirred at 105°C for 24 hours under a nitrogen atmosphere to obtain a solution containing a copolymer. As a result of GPC analysis of the obtained polymer, the weight average molecular weight (in terms of standard polystyrene) Mw was 2660.

<Synthesis Example 4>

In a reaction vessel equipped with a thermometer, a cooling tube, and a stirrer, 80.00 g of propylene glycol monomethyl ether, 9.25 g of dimethyloltricyclodecane diglycidyl ether (ADEKA RESIN EP-4088L, product of ADEKA CORPORATION), 6.05 g of 3,3'-dithiodipropionic acid (DTDPA) (product of Tokyo Chemical Industry Co., Ltd.), and 0.70 g of tetrabutylphosphonium bromide (product of Tokyo Chemical Industry Co., Ltd.) were dissolved, and the temperature was raised to 105°C under a nitrogen atmosphere.

The resulting mixture was stirred at 105°C for 24 hours under a nitrogen atmosphere to obtain a solution containing a copolymer. As a result of GPC analysis of the obtained polymer, the weight average molecular weight (in terms of standard polystyrene) Mw was 3460.

<Synthesis Example 5>

In a reaction vessel equipped with a thermometer, a cooling tube, and a stirrer, 80.00 g of propylene glycol monomethyl ether, 10.82 g of bisglycidyl terephthalate (EX-711, product of Nagase ChemteX Corporation), 8.23 g of 3,3'-dithiodipropionic acid (DTDPA) (product of Tokyo Chemical Industry Co., Ltd.), and 0.95 g of tetrabutylphosphonium bromide (product of Tokyo Chemical Industry Co., Ltd.) were dissolved, and the temperature was raised to 105°C under a nitrogen atmosphere.

The resulting mixture was stirred at 105°C for 24 hours under a nitrogen atmosphere to obtain a solution containing a copolymer. As a result of GPC analysis of the obtained polymer, the weight average molecular weight (in terms of standard polystyrene) Mw was 5980.

<Synthesis Example 6>

In a reaction vessel equipped with a thermometer, a cooling tube, and a stirrer, 80.00 g of propylene glycol monomethyl ether, 5.85 g of 1,6-bis(2,3-epoxypropoxy)naphthalene (HP-4032SS, product of DIC Corporation), 3.24 g of 3,3'-dithiodipropionic acid (DTDPA) (product of Tokyo Chemical Industry Co., Ltd.), and 0.37 g of tetrabutylphosphonium bromide (product of Tokyo Chemical Industry Co., Ltd.) were dissolved, and the temperature was raised to 105°C under a nitrogen atmosphere.

The resulting mixture was stirred at 105°C for 24 hours under a nitrogen atmosphere to obtain a solution containing a copolymer. As a result of GPC analysis of the obtained polymer, the weight average molecular weight (in terms of standard polystyrene) Mw was 2870.

<Synthesis Example 7>

In a reaction vessel equipped with a thermometer, a cooling tube, and a stirrer, 80.00 g of propylene glycol monomethyl ether, 10.53 g of diglycidyl ether of 2,2-bis(4-hydroxycyclohexyl)propane (EX-252, product of Nagase ChemteX Corporation), 4.64 g of 5-hydroxyisophthalic acid (5HIPA) (product of Tokyo Chemical Industry Co., Ltd.), and 0.82 g of tetrabutylphosphonium bromide (product of Tokyo Chemical Industry Co., Ltd.) were dissolved, and the temperature was raised to 105°C under a nitrogen atmosphere.

The resulting mixture was stirred at 105°C for 24 hours under a nitrogen atmosphere to obtain a solution containing a copolymer. As a result of GPC analysis of the obtained polymer, the weight average molecular weight (in terms of standard polystyrene) Mw was 5590.

(Example 1)

To 1.93 g of the solution containing the polymer obtained in each of Synthesis Examples 1 to 7 (solid content concentration: 20.0% by mass), 77.3 g of propylene glycol monomethyl ether acetate, and 0.07 g of pyridinium trifluoromethanesulfonate (Py-TFMS) (manufactured by Tokyo Chemical Industry Co., Ltd.) were added to obtain a 2.0% by mass solution. Thereafter, the solution was filtered using a polyethylene microfilter having a pore size of 0.05 μm to prepare a cavity forming composition.

The prepared solutions were used as Examples 1 to 4 and Comparative Examples 1 to 3 as shown in Table 1 below.

[Table 1]

| | Polymer | Acid catalyst | Solvent |
|---|---|---|---|
| Example 1 | Synthesis Example 1 | Py-TFMS | PGME |
| | 1.93g | 0.07g | 98.00g |
| Example 2 | Synthesis Example 2 | Py-TFMS | PGME |
| | 1.93g | 0.07g | 98.00g |
| Example 3 | Synthesis Example 3 | Py-TFMS | PGME |
| | 1.93g | 0.07g | 98.00g |
| Example 4 | Synthesis Example 4 | Py-TFMS | PGME |
| | 1.93g | 0.07g | 98.00g |
| Comparative Example 1 | Synthesis Example 5 | Py-TFMS | PGME |
| | 1.93g | 0.07g | 98.00g |
| Comparative Example 2 | Synthesis Example 6 | Py-TFMS | PGME |
| | 1.93g | 0.07g | 98.00g |
| Comparative Example 3 | Synthesis Example 7 | Py-TFMS | PGME |
| | 1.93g | 0.07g | 98.00g |

(Formation of coating film)

Each of the cavity forming compositions prepared in Examples 1 to 4 and the cavity forming compositions prepared in Comparative Examples 1 to 3 was applied onto a silicon substrate by spin coating, and baked at a predetermined baking temperature for 60 seconds to prepare a coating film having a film thickness of 43 nm.

(Decomposition performance test of composition by firing)

Each of the cavity forming compositions prepared in Examples 1 to 4 and the cavity forming compositions prepared in Comparative Examples 1 to 3 was applied by spin coating and fired at 220°C for 60 seconds to prepare a coating film on a silicon substrate. The coating film had a film thickness of about 43 nm. A thermal decomposition ratio was measured using the obtained coating film.

The results of the decomposition ratios in the obtained Examples and Comparative Examples are shown in Table 2.

Note that the details of measurement conditions of the thermal decomposition ratio are as follows.

First, the thickness of the coating film was measured using VM-3210 (manufactured by SCREEN Semiconductor Solutions Co., Ltd.). Thereafter, the silicon substrate to which the cavity forming composition had been applied was heated for 30 minutes with a plate preheated to 400°C under a nitrogen atmosphere. Finally, the film thickness of the resulting coating film on the substrate was measured again using RE-3100 and RE-3500 (manufactured by SCREEN Semiconductor Solutions Co., Ltd.). From the obtained results, a thermal decomposition ratio of the coating film was calculated using the following formula 1. As a result of the examination, the decomposition ratio was as shown in Table 2.

$$\text{(Decomposition ratio [\%])} = 100 \times (1 - T_1/T_0) \quad \text{Formula 1}$$

$T_0$ = film thickness of coating film before firing decomposition
$T_1$ = film thickness of coating film after firing decomposition

[Table 2]

| | Decomposition ratio (%) |
|---|---|
| Example 1 | 97.9 |
| Example 2 | 98.8 |

(continued)

| | Decomposition ratio (%) |
|---|---|
| Example 3 | 97.8 |
| Example 4 | 96.8 |
| Comparative Example 1 | 93.3 |
| Comparative Example 2 | 84.2 |
| Comparative Example 3 | 90.8 |

Although the decomposition ratio is desirably 95% or more, the decomposition ratio was less than 95% in Comparative Examples 1 to 3, whereas the decomposition ratio was 95% or more all in Examples 1 to 4.

From the results in Table 2 above, it was found that all the coating films prepared using the cavity forming compositions of Examples 1 to 4 containing a polymer containing an alicyclic hydrocarbon structural moiety and not containing an aromatic hydrocarbon structural moiety in a main chain have a high decomposition ratio.

Industrial Applicability

The cavity forming composition according to the present invention provides a film excellent in composition removal performance by firing.

Reference Signs List

| | |
|---|---|
| 1 | Semiconductor substrate |
| 2 | Conductive wiring pattern |
| 3A | Cavity forming composition |
| 3B | Cavity forming film |
| 3C | Cavity |
| 4 | Insulating layer |

**Claims**

**1.** A cavity forming composition for forming a cavity between conductive wiring patterns on a semiconductor substrate, the cavity forming composition comprising:
a polymer containing an alicyclic hydrocarbon structural moiety and not containing an aromatic hydrocarbon structural moiety; and a solvent.

**2.** The cavity forming composition according to claim 1, wherein the polymer is formed of a condensate of a diepoxy compound and a dicarboxylic acid.

**3.** The cavity forming composition according to claim 1, wherein the polymer contains a disulfide bond.

**4.** The cavity forming composition according to claim 1, further comprising an acid catalyst.

**5.** A method for manufacturing a semiconductor element, the method comprising:

a step (A) of applying the cavity forming composition according to any one of claims 1 to 4 onto a semiconductor substrate on which conductive wiring patterns are formed;
a step (B) of heating the semiconductor substrate after the step (A) to form a cavity forming film formed of the cavity forming composition between the conductive wiring patterns;
a step (C) of forming an insulating layer on the conductive wiring patterns and the cavity forming film between the conductive wiring patterns after the step (B); and
a step (D) of heating the semiconductor substrate to burn out the cavity forming film after the step (C).

**6.** The method for manufacturing a semiconductor element according to claim 5, wherein

in the step (B), the cavity forming film is formed also on the conductive wiring patterns, and
the method comprises a step (E) of removing the cavity forming film on the conductive wiring patterns before the step (C).

**7.** The method for manufacturing a semiconductor element according to claim 5, the method comprising
a step (F) of removing the cavity forming film which is present on the conductive wiring patterns and is formed of the cavity forming composition between the step (A) and the step (B).

**8.** The method for manufacturing a semiconductor element according to claim 5, wherein in the step (C), the insulating layer is formed by chemical vapor deposition.

FIG. 1A

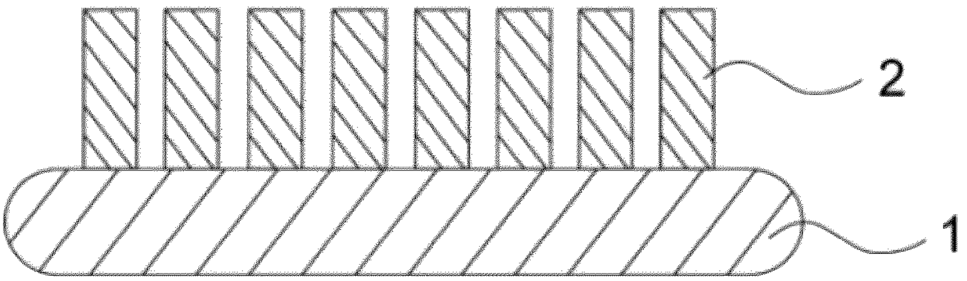


FIG. 1B

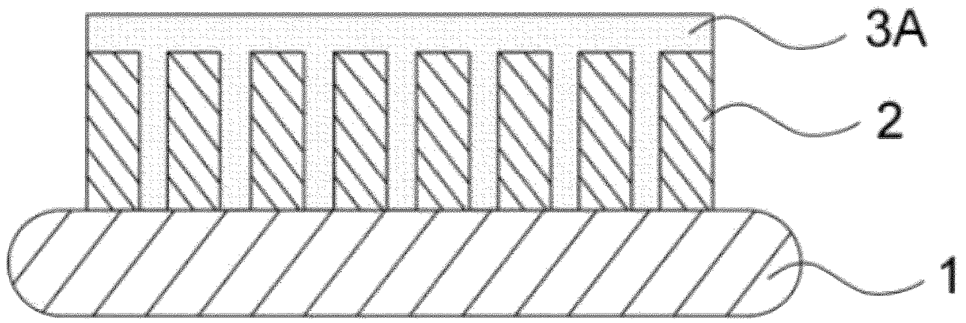

FIG. 1C

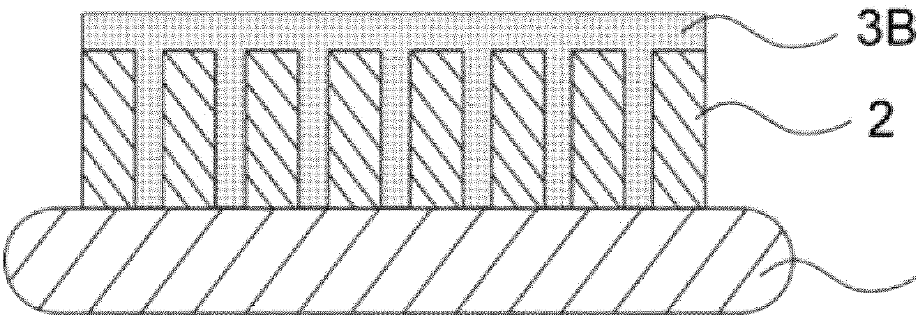


FIG. 1D

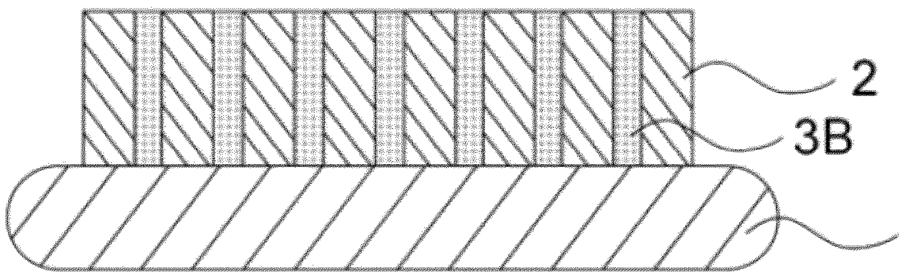

FIG. 1E

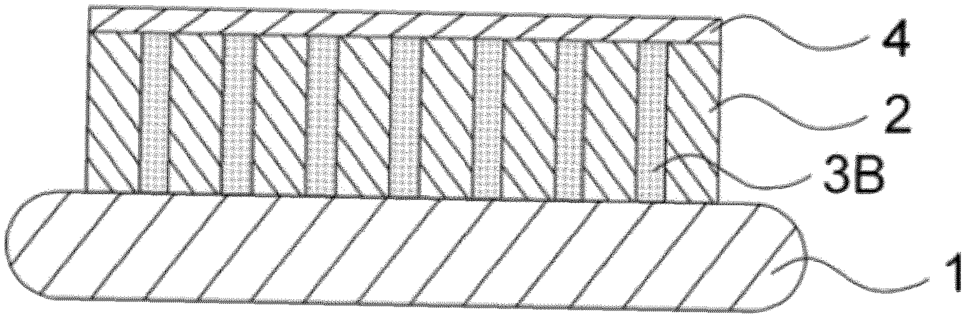


FIG. 1F

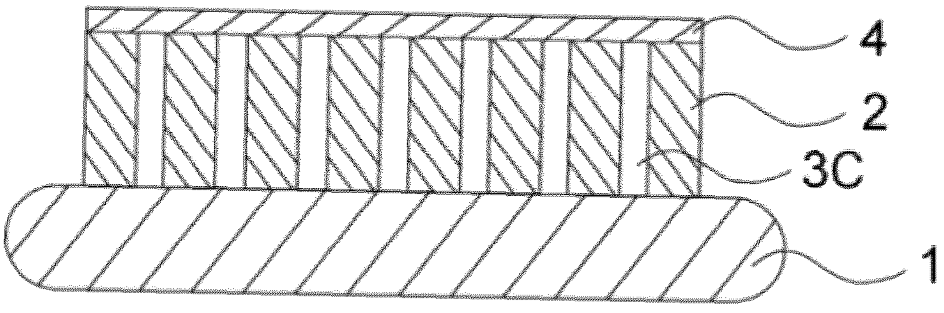

## INTERNATIONAL SEARCH REPORT

International application No.
**PCT/JP2024/007708**

**A. CLASSIFICATION OF SUBJECT MATTER**

***H01L 21/768***(2006.01)i; ***C08G 59/42***(2006.01)i; ***C08G 63/42***(2006.01)i; ***C08G 63/688***(2006.01)i; ***H01L 21/312***(2006.01)i; ***H01L 23/532***(2006.01)i
FI: H01L21/90 N; C08G59/42; C08G63/42; C08G63/688; H01L21/312 A

According to International Patent Classification (IPC) or to both national classification and IPC

**B. FIELDS SEARCHED**

Minimum documentation searched (classification system followed by classification symbols)

H01L21/768; C08G59/42; C08G63/42; C08G63/688; H01L21/312; H01L23/532

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2004-207475 A (ASAHI KASEI KABUSHIKI KAISHA) 22 July 2004 (2004-07-22) paragraphs [0002]-[0041] | 1 |
| Y | | 3-8 |
| A | | 2 |
| Y | JP 2004-266244 A (ROHM & HAAS ELECTRONIC MATERIALS LLC) 24 September 2004 (2004-09-24) paragraphs [0070], [0089]-[0090] | 3-4 |
| Y | US 2012/0261788 A1 (INTERNATIONAL BUSINESS MACHINES CORP.) 18 October 2012 (2012-10-18) paragraphs [0022]-[0039], fig. 1E-1J | 5-6, 8 |
| Y | JP 2015-111610 A (MERCK PERFORMANCE MATERIALS MFG GK) 18 June 2015 (2015-06-18) paragraphs [0034]-[0037], fig. 1 | 5, 7-8 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **10 May 2024** | **21 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**

International application No.
**PCT/JP2024/007708**

**C. DOCUMENTS CONSIDERED TO BE RELEVANT**

| Category* | Citation of document, with indication, where appropriate, of the relevant passages | Relevant to claim No. |
|---|---|---|
| A | JP 2004-149609 A (JSR CORPORATION) 27 May 2004 (2004-05-27)<br>entire text, all drawings | 1-8 |

Form PCT/ISA/210 (second sheet) (July 2022)

**INTERNATIONAL SEARCH REPORT**
**Information on patent family members**

International application No.
**PCT/JP2024/007708**

| Patent document cited in search report | Publication date (day/month/year) | Patent family member(s) | Publication date (day/month/year) |
|---|---|---|---|
| JP 2004-207475 A | 22 July 2004 | (Family: none) | |
| JP 2004-266244 A | 24 September 2004 | US 2004/0137728 A1<br>paragraphs [0074], [0091]-[0092]<br>US 2008/0038518 A1<br>EP 1398831 A2<br>TW 200414413 A<br>KR 10-2004-0024524 A<br>CN 1495877 A | |
| US 2012/0261788 A1 | 18 October 2012 | US 2015/0054122 A1 | |
| JP 2015-111610 A | 18 June 2015 | (Family: none) | |
| JP 2004-149609 A | 27 May 2004 | US 2004/0092127 A1<br>EP 1418618 A2<br>TW 200424235 A<br>KR 10-2004-0038723 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H09172068 A
- JP 2021114524 A